# EUROPEAN PATENT SPECIFICATION

(11) **EP 1 344 746 B1**
(45) Date of publication and mention of the grant of the patent: **02.03.2011**
(21) Application number: 03251321.0
(22) Date of filing: 05.03.2003
(51) Int. Cl.: B81C 1/00, B81B 3/00

(54) **MEMS device and fabrication method thereof**
MEMS-Bauelemente und Verfahren zu deren Herstellung
MEMS et procédé de production de MEMS

(30) Priority: 11.03.2002 KR 2002012985
(43) Date of publication of application: 17.09.2003
(73) Proprietor: SAMSUNG ELECTRONICS CO., LTD., Suwon-City, Kyungki-do (KR)
(72) Inventor: Lee, Eun-sung, Joong-gu, Daejeon-city (KR); Kim, Chung-woo, 101-705 Park Town Daelim Apt., Gyeonggi-do (KR); Song, In-sang, Gwanak-gu, Seoul (KR); Kim, Jong-seok, Taean-eub, Hwasung-gun, Gyunggi-do (KR); Lee, Moon-chul, Sungnam-city, Gyunggi-do, Korea (KR)
(74) Representative: Ertl, Nicholas Justin

(56) References cited:
- WO-A-01/01434
- WO-A-01/56920
- WO-A-02/16150
- US-A- 4 571 661
- US-A- 5 367 136

## Description

The present invention relates to a MEMS device and fabrication method thereof, and more particularly to an electrostatic driving MEMS device having a driving electrode in an embedded structure and fabrication method thereof.

The Micro electro mechanical system is a technology that implements mechanical and electrical parts, using a semiconductor process. The MEMS device generally has driving parts floating to be movable on the substrate in order for the device fabricated in use of the MEMS technology to perform mechanical operations.

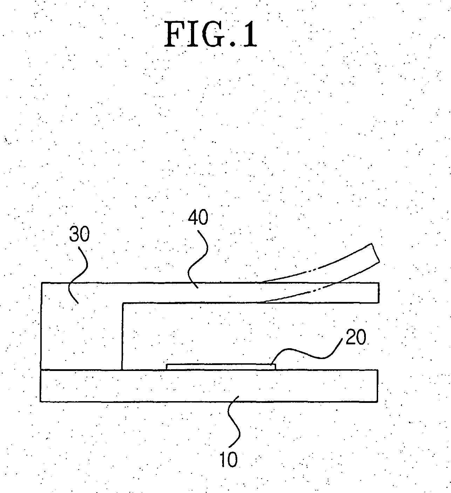

Fig. 1 is a view for schematically illustrating such a MEMS device.

The MEMS device has a substrate 10, a fixing part 30 fixed on the substrate 10, and a driving part 40 extended from the fixing part 30. The fixing part 30 is referred to as an anchor or a support in general, fixing the driving part 40 to the substrate 10.

The driving part 40 is spaced to float over the substrate 10, which is upwards and downwards movable as shown in dotted lines by a predetermined driving force occurring from an electrode part 20 formed on the substrate 10. The driving part 40 is fabricated in a shape of such as beam, membrane, or the like depending on necessity.

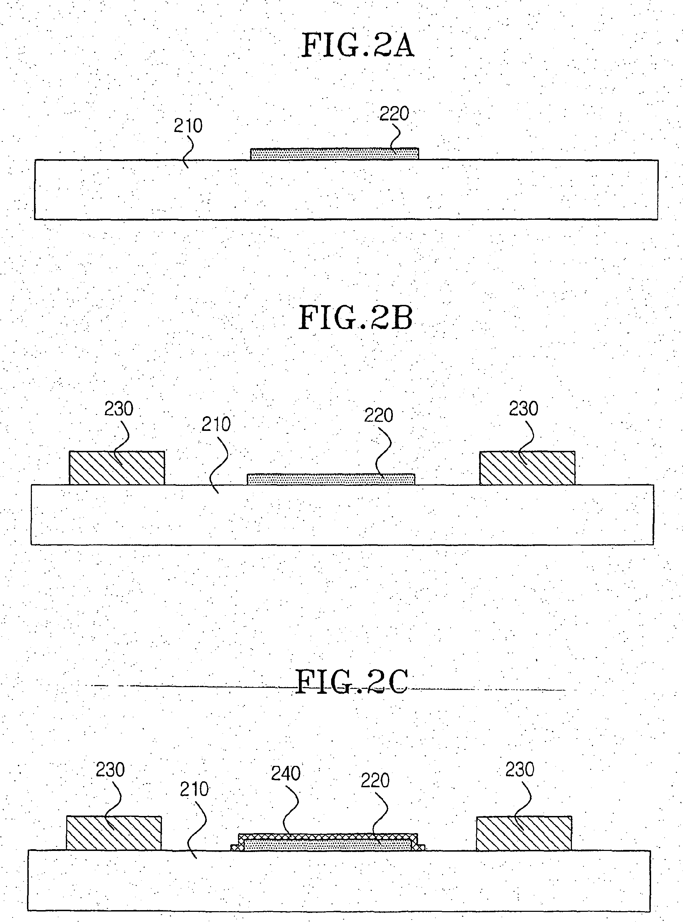

Fig. 2A to Fig. 2E are views for sequentially illustrating a process for fabricating a general electrostatic drive-type RF MEMS device, as an example.

As shown in Fig. 2A, a driving electrode layer 220 is formed on the substrate 210 through patterning for an electrostatic driving, and metal layers 230 are formed as shown in Fig. 2B to match in shapes with an anchor part as a fixing part fixed on the substrate 210 and an RF lines as input and/or output terminals of an RF signal. At this time, the metal layer 230 is formed in a thick layer of 2 to 3µm in consideration of the skin depth effect.

Next, an insulation layer 240 is formed to wrap up the driving electrode layer 220 formed on the substrate 210.

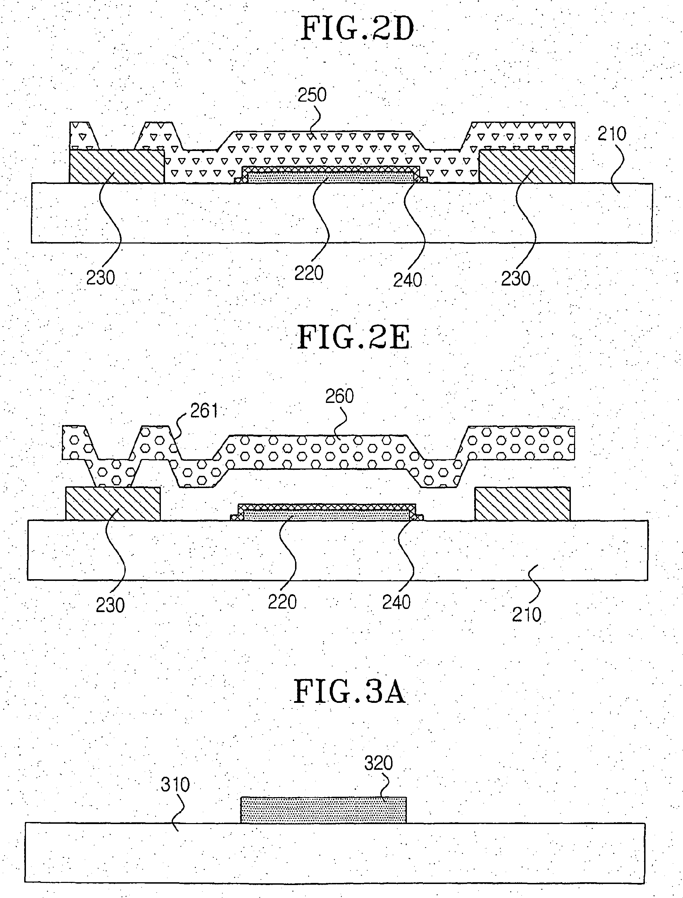

Thereafter, as shown in Fig. 2D, a sacrificial layer 250 is formed on the substrate 210, and the sacrificial layer of the anchor part fixed on the substrate 210 is etched through predetermined patterning. A MEMS structure layer 260 is formed on the patterned sacrificial layer 250, as shown in Fig. 2E.

Thereafter, predetermined etching access holes (not shown) are formed in the driving part 260 which is the MEMS structure layer, and etchant is supplied through the etching access holes to selectively etch only the sacrificial layer 250. Accordingly, as shown in Fig. 2F, a MEMS device is fabricated that the driving part 260 floats over the substrate 210 through the removal of the sacrificial layer 250.

As stated above, a general fabrication process proceeds regardless of a step-height difference between the metal layers 230 of RF lines and the driving electrode layer 220.

Accordingly, such a step-height difference between the metal layers 230 of RF lines and the driving electrode layer 220 causes the driving part 260 formed by a subsequent procedure to come uneven, as shown in Fig. 2E, so that a fabricated MEMS device becomes less reliable. However, since such unevenness which occurs on the driving part 260 is not expected from the design, there exists a significant error between the design and the product made by the fabrication process. Further, this unevenness causes a problem that incomplete driving can result when the MEMS device is driven.

Further, in the fabrication process shown in Fig. 2D to Fig. 2E, a connection part 261 of the MEMS structure layer 260 formed on an anchor part and the substrate 210 is formed in a bent shape that is relatively thinner than the anchor part and the MEMS structure layer 260. Accordingly, the connection part in this thin and bent shape causes a problem in the solidity of the MEMS device. In particular, the general operation of the MEMS device is characterised by the movements of the MEMS structure, namely the driving part 260.

WO 01/01434 discloses a MEMS switch in which a moveable beam comprises a biasing layer and an electrode layer. The beam is attracted to electrodes embedded in the underlying substrate when a voltage is applied. WO 01/56920 discloses a MEMS device in which a beam is suspended over an underlying substrate. The electrodes in the substrate are formed as filled vias. WO 02/16150 discloses a MEMS device in which a beam is suspended over an underlying substrate. The electrodes of the substrate is formed as a raised electrode layer.

US 4 571 661 describes the formation of a MEMS vibration sensor beam. A beam structure is formed over a sacrificial layer having two differently doped regions. The beam is released by a dopant-selective etching such that a highly doped part of the sacrificial layer is not actually etched. This part lies under the beam at the point where the beam is anchored to the substrate and since it remains after beam release it adds structural support to the beam.

According to the invention, there is provided a method for fabricating a MEMS device as in a claim 1.

The invention thus provides a MEMS device having the enhanced reliability and stable driving capability.

The electrode part may include an electrode and an insulation layer overlapping the electrode to electrically isolate the driving part and the electrode, the electrode being formed in an embedded structure as to the insulation layer.

The step difference between the RF lines and the driving electrode can be removed with this structure, so the MEMS structure layer to be subsequently formed for the driving part driven by an electrostatic force can be prevented from being transformed.

Examples of the invention will now be described in detail with reference to the attached drawings, in which:
Fig. 1 is a cross-sectioned side view for schematically illustrating a general MEMS device;
Fig. 2A to Fig. 2E are views for sequentially showing a process for fabricating a general electrostatic drive-type MEMS device;
Fig. 3A to Fig. 3F are views for sequentially showing a process for fabricating an electrostatic drive-type RF MEMS relay according to an embodiment of the present intention; and
Fig. 4A to Fig. 4G are views for sequentially showing a process for fabricating another electrostatic drive-type RF MEMS relay according to another embodiment of the present invention.

Hereinafter, the present invention will be described in detail with reference to the accompanying drawings.

An electrostatic drive-type RF MEMS relay is described below as a MEMS device according to an embodiment of the present invention.

Fig. 3A to Fig. 3F are views for sequentially showing a process for fabricating an electrostatic drive-type MEMS relay according to an embodiment of the present invention.

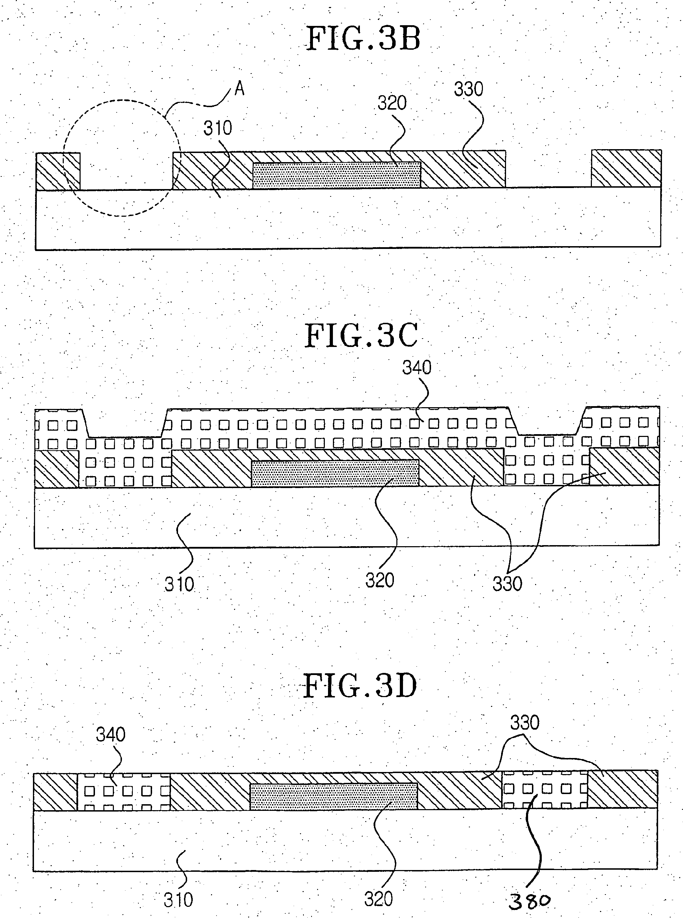

First, as shown in Fig. 3A, a driving electrode layer 320 is formed on a substrate 310 through patterning for electrostatic driving, and, as shown in Fig. 3B, a flattening mold 330 is formed as an insulation layer on the substrate 310 on which the driving electrode layer 320 is formed.

A Tetra-Ethyl-Ortho-Silicate(TEOS) oxide film is generally used for the insulation layer.

Thereafter, the flattening mold 330 of the insulation layer is patterned, and the regions for an anchor part A of the MEMS relay and contact parts for input and output terminals of an RF signal are etched. That is, the insulation layer 330 formed in the flattening mold becomes an insulation layer of the driving electrode layer 320. The electrode layer 320 is formed to prevent the electric short-circuit of the driving electrode layer 320 and a driving part to be described later.

Next, as shown in Fig. 3C, a metal layer 340 is formed to a predetermined thickness on the substrate where regions for the anchor part A and the contact part (380) are etched. For example, a metal having high conductivity is employed, such as gold(Au), for the metal layer 340.

As shown in Fig. 3D, a step is performed for planarizing the substrate on which the metal layer 340 is formed in a predetermined thickness. The planarizing step is accomplished by polishing.

When the planarizing step is performed by the polishing, the time when the insulation layer 330 formed underneath the metal layer 340 is revealed is monitored, and it is decided how far the planarizing step progresses. That is, as shown in Fig. 3D, the polishing progresses until the insulation layer 330 is revealed.

At this time, the metal layer 340 for the RF lines is formed in a thick film of 2 to 3µm in consideration of the skin depth effect, and the flattening mold 330 of the insulation layer is formed in a thick film of 2 to 3µm.

Accordingly, the metal layer 340 is formed on the anchor part A and the RF line parts in a thickness matching the thickness of the insulation layer mold previously processed, so that the electrode part in which the driving electrode layer 320 and the insulation layer 330 are formed and the RF lines are evenly formed in thickness without a difference of step heights.

Therefore, the electrostatic drive-type MEMS relay is formed in a structure that the driving electrode 320 thereof is embedded in the insulation layer 330.

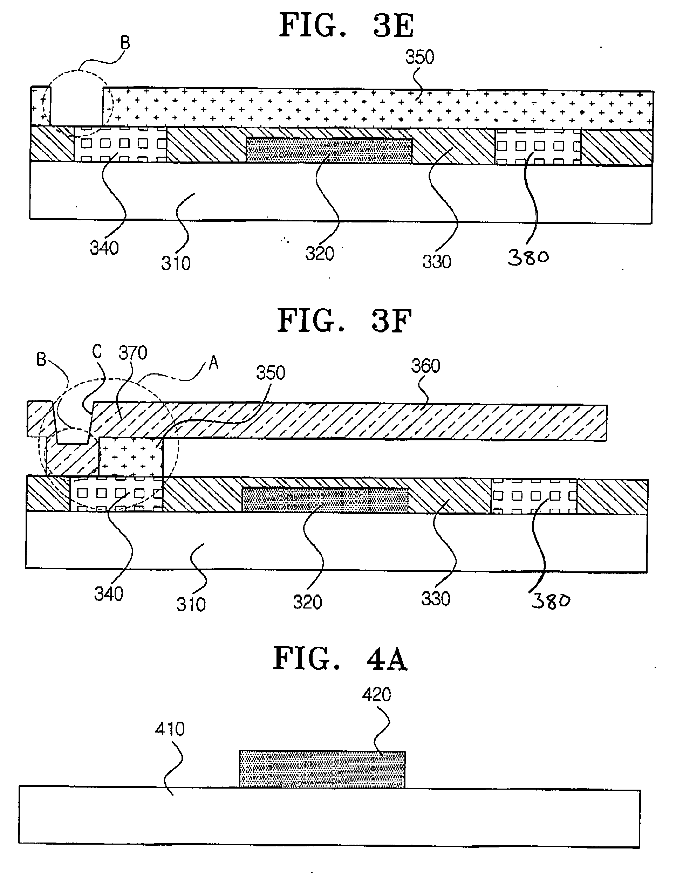

Next, as shown in Fig. 3E, a sacrificial layer 350 is formed on the planarized substrate 310, and the sacrificial layer is etched to form a groove-shaped space in one rim portion B of the anchor part A through predetermined patterning. The sacrificial layer 350 may be formed of material such as aluminum(Al), copper(Cu), oxide, nickel(Ni), or the like.

As shown in Fig. 3F, a MEMS structure layer 360 is formed on the patterned sacrificial layer 350. The MEMS structure layer 360 is formed of a deposited metal layer of a substance such as gold(Au). Accordingly, the MEMS structure layer 360 is formed in the groove-shaped space formed in the rim portion B of the anchor part, and the MEMS structure layer 360 is also formed on the substrate 310 on which the sacrificial layer 350 is formed.

Thereafter, predetermined etching access holes (not shown) are formed in the MEMS structure layer 360 in which the driving part 360 is formed which is driven by the driving electrode 320, an etchant able to selectively etch only the sacrificial layer 350 is supplied through the etching access holes. Accordingly, the sacrificial layer 350 is removed, as shown in Fig. 3F, so that the MEMS relay having the driving part 360 floating over the substrate 310 is fabricated.

At this time, a sidewall C is formed in the connection part of the anchor part and the driving part by the MEMS structure layer 360 formed in the rim B of the anchor part, as shown in Fig. 3F, so that the sacrificial layer 350 adjacent to the connection part is not removed by the etchant, but remains.

The process previously shown in Fig. 3E and Fig. 3F is described in detail in Republic of Korea patent Application No. 2001-80358 entitled "MEMS structure having blocked-sacrificial layer support/anchor and a fabrication method of the same", which has been filed by the same Applicant as that of the present invention.

As stated above, the step-height difference, namely the thickness difference between the RF lines of the contact parts (340, 380) and the driving electrode 320 formed in a structure embedded in the insulation layer 330 of the electrode part, is removed through the planarizing process, so that a MEMS relay can be fabricated which has the enhanced reliability and stable drive capability.

Further, a step for forming the insulation layer 330 on the driving electrode layer 320 compared to the prior art can be excluded, to thereby simplify the fabrication process.

In the meantime, the sacrificial layer 350 of the anchor part remains by the sidewall C formed in the connection part of the anchor part A and the driving part 360, so that a more solid MEMS device can be fabricated.

Fig. 4A to Fig. 4G are views for sequentially illustrating a planarizing process for an electrostatic drive-type MEMS relay according to another embodiment of the present invention, in which a driving electrode layer 420 formed on the substrate 410 is formed without a step-height difference as to metal layers 440 of RF lines.

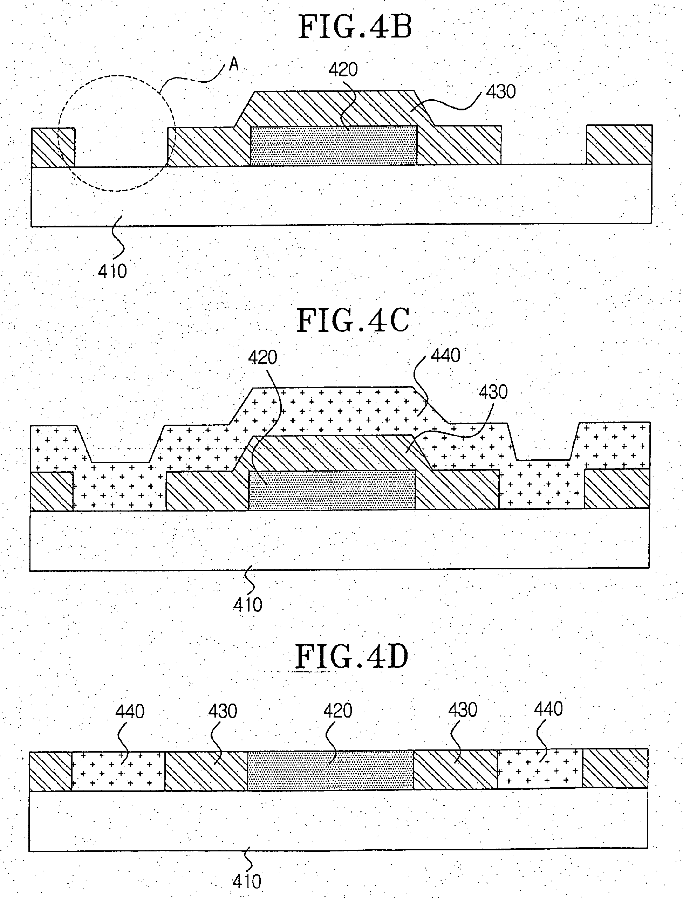

First, as shown in Fig. 4A, the driving electrode layer 420 patterned on the substrate 410 is formed in a predetermined thickness for electrostatic driving, and, as shown in Fig. 4B, the insulation layer 430 is formed on the substrate 410 on which the driving electrode layer 420 is formed. Thereafter, the regions of the anchor part A of the MEMS relay and the contact parts of the RF lines are patterned and etched.

Next, as shown in Fig. 4C, the metal layer 440 is deposited in a predetermined thickness on the substrate 410 in which the regions of the anchor part and the contact parts have been etched.

A planarizing step is performed through the polishing of the substrate on which the metal layer 440 is formed in a predetermine thickness. As shown in Fig. 4D, the polishing progresses until the driving electrode layer 420 is revealed. Further, the metal layers 440 of the RF lines are polished to be formed in a thick film of 2 to 3µm in consideration of the skin depth effect.

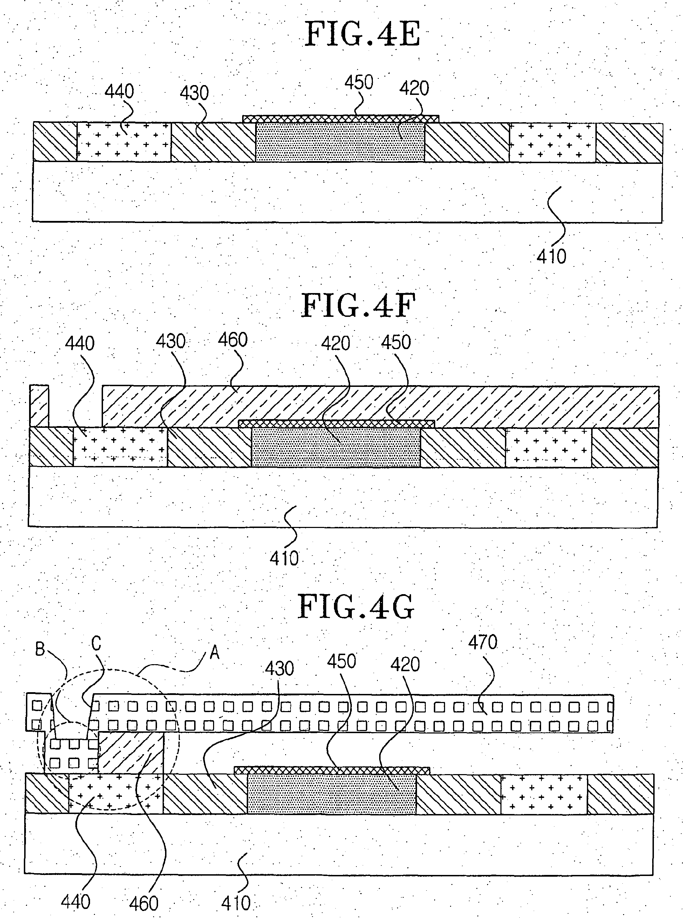

Next, as shown in Fig. 4E, an insulation layer 450 overlapping the driving electrode layer 420 is formed.

Accordingly, the metal layers 440 of contact part and the driving electrode layer 420 are formed planarized compared to the prior art.

Next, the fabrication steps of Fig. 4F and Fig. 4G are the same as those of Fig. 3E and Fig. 3F for the above-described embodiment of the present invention which is described in Republic of Korea Patent Application No. 2001-80358, so the description thereto will be omitted.

As stated above, the step-height difference between the RF lines 440 and the driving electrode 420 is removed so that the driving part of MEMS structure layer 470 fabricated in the subsequent steps is prevented from being transformed and a more solid MEMS device can be fabricated.

Accordingly, a MEMS relay having the enhanced reliability and the stabilized drive capability can be fabricated.

According to the present invention, the step difference between the RF lines and the driving electrode is removed, so the MEMS structure layer to be subsequently formed for the driving part driven by an electrostatic force can be prevented from being transformed.

Further, the sacrificial layer of the anchor part remains by the sidewall formed in the connection part of the anchor part and the driving part, so that a more solid MEMS device can be fabricated.

Although the preferred embodiments of the present invention have been described, it will be understood by those skilled in the art that the present invention should not be limited to the described preferred embodiments, but various changes and modifications can be made within the spirit and scope of the present invention as defined by the appended claims.

## Claims

1. A method for fabricating a MEMS device having a fixing part (370) fixed to a substrate (310), a driving part (360) connected to the fixing part and floating over the substrate, a driving electrode (320) for driving the driving part by a predetermined driving force, and contact parts (380) selectively switchable with the driving part, comprising the steps of:
patterning the driving electrode (320) on the substrate;
forming an insulation layer (330) on the substrate on which the driving electrode is formed;
patterning the insulation layer (330) and etching away parts of the insulation layer (330) an which the fixing part (370) and in which the contact parts (380) are to be formed;
forming a metal layer (340) over the substrate including the etched regions;
planarizing the metal layer until the insulation layer (330) is exposed;
forming a sacrificial layer (350) on the exposed insulation layer and the planarized metal layer;
patterning the sacrificial layer (350) to form a space (B) overlapping at least one portion of a region matched with the region in which the fixing part (370) is to be formed, the space (B) extending to touch metal layer (340);
forming a MEMS structure layer (360) on the sacrificial layer (350) to form sidewalls (C) in the space (B), and forming the fixing part (370) and the driving part (360) on the sacrificial layer (350); and
etching the sacrificial layer using an etchant,
wherein in the etching of the sacrificial layer, the etchant supplied to a region of the sacrificial layer (350) between the metal layer (340) and the driving part (360) is prevented, and said region is adjacent to the fixing part (370), and the rest of the sacrificial layer (350) is etched.

2. The method as claimed in claim 1, wherein, in the step for forming the insulation layer (330), the insulation layer is formed in a thicker film at least than the driving electrode (320), and the driving electrode (320) has an embedded structure in the insulation layer (330).

3. The method as claimed in claim 1, wherein the space is formed by removing a portion of the sacrificial layer formed on the metal layer and the insulation layer through patterning.

4. The method as claimed in any preceding claim, wherein the MEMS structure layer (360) forms a connecting part between the fixing part (370) and the driving part (360), and wherein a width of the connection part is narrower than that of the fixing part (370).

5. The method as claimed in any preceding claim, before the removal step is performed, further comprising the step of forming etching access holes in the MEMS structure layer (360).

6. The method as claimed in claim 5, wherein the etching access holes are formed in the driving part (360).

## Patentansprüche

1. Verfahren zur Herstellung eines MEMS-Bauelements mit einem an einem Substrat befestigten Befestigungsteil (370), einem Antriebsteil (360), der mit dem Befestigungsteil verbunden ist und über dem Substrat schwebt, einer Antriebselektrode (320) zum Antreiben des Antriebsteils mit einer vorbestimmten Antriebskraft, und Kontaktteilen (380), die selektiv mit dem Antriebsteil schaltbar sind, das die folgenden Schritte beinhaltet:
Strukturieren der Antriebselektrode (320) auf dem Substrat;
Bilden einer Isolierschicht (330) auf dem Substrat, auf dem die Antriebselektrode ausgebildet ist;
Strukturieren der Isolierschicht (330) und Wegätzen von Teilen der Isolierschicht (330), auf der der Befestigungsteil (370) und in der die Kontaktteile (380) ausgebildet werden sollen;
Bilden einer Metallschicht (340) über dem Substrat einschließlich der geätzten Regionen;
Planarisieren der Metallschicht, bis die Isolierschicht (330) exponiert ist;
Bilden einer Opferschicht (350) auf der exponierten Isolierschicht und der planarisierten Metallschicht;
Strukturieren der Opferschicht (350) zum Bilden eines Raums (B), der wenigstens einen Abschnitt einer Region überlappt, die mit der Region übereinstimmt, in der der Befestigungsteil (370) gebildet werden soll, wobei sich der Raum (B) bis an die Metallschicht (340) erstreckt;
Bilden einer MEMS-Strukturschicht (360) auf der Opferschicht (350) zum Bilden von Seitenwänden (C) in dem Raum (B) und Bilden des Befestigungsteils (370) und des Antriebsteils (360) auf der Opferschicht (350); und
Ätzen der Opferschicht mit einem Ätzmittel,
wobei beim Ätzen der Opferschicht ein Fließen des Ätzmittels zu einer Region der Opferschicht (350) zwischen der Metallschicht (340) und dem Antriebsteil (360) verhindert wird und wobei sich die genannte Region neben dem Befestigungsteil (370) befindet und der Rest der Opferschicht (350) geätzt wird.

2. Verfahren nach Anspruch 1, wobei in dem Schritt des Bildens der Isolierschicht (330) die Isolierschicht zu einem Film gebildet wird, der wenigstens dicker ist als die Antriebselektrode (320), und die Antriebselektrode (320) eine eingebettete Struktur in der Isolierschicht (330) hat.

3. Verfahren nach Anspruch 1, wobei der Raum durch Entfernen eines Teils der auf der Metallschicht gebildeten Opferschicht und der Isolierschicht durch Strukturieren gebildet wird.

4. Verfahren nach einem der vorherigen Ansprüche, wobei die MEMS-Strukturschicht (360) einen Verbindungsteil zwischen dem Befestigungsteil (370) und dem Antriebsteil (360) bildet und wobei eine Breite des Verbindungsteils geringer ist als die des Befestigungsteils (370).

5. Verfahren nach einem der vorherigen Ansprüche, das vor dem Ausführen des Entfernungsschrittes ferner den Schritt des Bildens von Ätzzugangslöchern in der MEMS-Strukturschicht (360) beinhaltet.

6. Verfahren nach Anspruch 5, wobei die Ätzzugangslöcher im Antriebsteil (360) ausgebildet werden.

## Revendications

1. Procédé pour former un dispositif MEMS ayant une partie de fixation (370) fixée à un substrat (310), une partie de commande (360) connectée à la partie de fixation et flottant au-dessus du substrat, une électrode de commande (320) pour commander la partie de commande par une force de commande prédéterminée, et des parties de contact commutables sélectivement (380) avec la partie de commande, comprenant les étapes consistant à :
former un motif de l'électrode de commande (320) sur le substrat ;
former une couche d'isolation (330) sur le substrat sur lequel est formée l'électrode de commande ;
former un motif sur la couche isolante (330) et enlever par gravure des parties de la couche d'isolation (330) sur laquelle la partie de fixation (370) et dans laquelle les parties de contact (380) doivent être formées ;
former une couche métallique (340) par-dessus le substrat, y compris les zones gravées ;
planariser la couche métallique jusqu'à ce que la couche d'isolation (330) soit exposée ;
former une couche sacrificielle (350) sur la couche d'isolation exposée et la couche métallique planarisée ;
former un motif sur la couche sacrificielle (350) pour former un espace (B) recouvrant au moins une partie d'une zone correspondant à la zone dans laquelle doit être formée la partie de fixation (370), l'espace (B) s'étendant de manière à toucher la couche métallique (340) ;
former une couche de structure MEMS (360) sur la couche sacrificielle (350) pour former des parois latérales (C) dans l'espace (B), et former la partie de fixation (370) et la partie de commande (360) sur la couche sacrificielle (350) ; et
graver la couche sacrificielle avec un agent de gravure,
dans lequel, dans la gravure de la couche sacrificielle, l'agent de gravure fourni à une zone de la couche sacrificielle (350) entre la couche métallique (340) et la partie d'entraînement (360) est empêché, et ladite zone est adjacente à la partie de fixation (370), et le reste de la couche sacrificielle (350) est gravé.

2. Procédé selon la revendication 1, dans lequel, dans l'étape de formation de la couche d'isolation (330), la couche d'isolation est formée dans un film plus épais qu'au moins l'électrode de commande (320), et l'électrode de commande (320) a une structure intégrée dans la couche d'isolation (330).

3. Procédé selon la revendication 1, dans lequel l'espace est formé par enlèvement d'une partie de la couche sacrificielle formée sur la couche métallique et la couche d'isolation par formation d'un motif.

4. Procédé selon l'une quelconque des revendications précédentes, dans lequel la couche de structure MEMS (360) forme une partie de connexion entre la partie de fixation (370) et la partie de commande (360), et dans lequel une largeur de la partie de connexion et plus étroite que celle de la partie de fixation (370).

5. Procédé selon l'une quelconque des revendications précédentes, avant l'exécution de l'étape d'enlèvement, comprenant en outre l'étape de formation de trous d'accès de gravure dans la couche de structure MEMS (360).

6. Procédé selon la revendication 5, dans lequel les trous d'accès de gravure sont formés dans la partie de commande (360).
